Europäisches Patentamt

European Patent Office

Office européen des brevets

(19)

(11) Publication number : **0 377 959 B1**

(12) **EUROPEAN PATENT SPECIFICATION**

(45) Date of publication of patent specification :
25.01.95 Bulletin 95/04

(51) Int. Cl.⁶ : **G11C 19/28**

(21) Application number : **89312415.6**

(22) Date of filing : **29.11.89**

(54) **A method of driving a charge detection circuit.**

(30) Priority : **10.01.89 JP 3263/89**

(43) Date of publication of application :
**18.07.90 Bulletin 90/29**

(45) Publication of the grant of the patent :
**25.01.95 Bulletin 95/04**

(84) Designated Contracting States :
**DE FR GB**

(56) References cited :
**US-A- 3 969 634**
**IBM TECHNICAL DISCLOSURE BULLETIN,**
**vol. 22, no. 7, December 1979, pages**
**2978,2979; L.M. TERMAN et al.: "CCD mul-**
**tilevel storage detection scheme"**
**IDEM**
**IDEMC.H. SEQUIN et al.: "Charge Transfer**
**Devices", 1975, pages 46-61, AcademicPress**
**Inc., New York, US**
**IDEM**

(73) Proprietor : **MITSUBISHI DENKI KABUSHIKI**
**KAISHA**
**2-3, Marunouchi 2-chome**
**Chiyoda-ku**
**Tokyo (JP)**

(72) Inventor : **Kimata, Masafumi Mitsubishi Denki**
**K.K.**
**LSI Kenkyusho, No. 1**
**Mizuhara 4-chome**
**Itami-shi Hyogo-ken (JP)**

(74) Representative : **Beresford, Keith Denis Lewis**
**et al**
**BERESFORD & Co.**
**2-5 Warwick Court**
**High Holborn**
**London WC1R 5DJ (GB)**

EP 0 377 959 B1

## Description

### FIELD OF THE INVENTION

The present invention relates to a method of driving a charge detection circuit, and more particularly to a driving method capable of improving the characteristics of the charge detection circuit which is used as an output circuit of a semiconductor integrated circuit.

### BACKGROUND OF THE INVENTION

As a charge coupled device among semiconductor integrated circuits (hereinafter referred to as "CCD"), there is a charge detection circuit which is called as a floating diffusion amplifier which conducts a charge-voltage conversion.

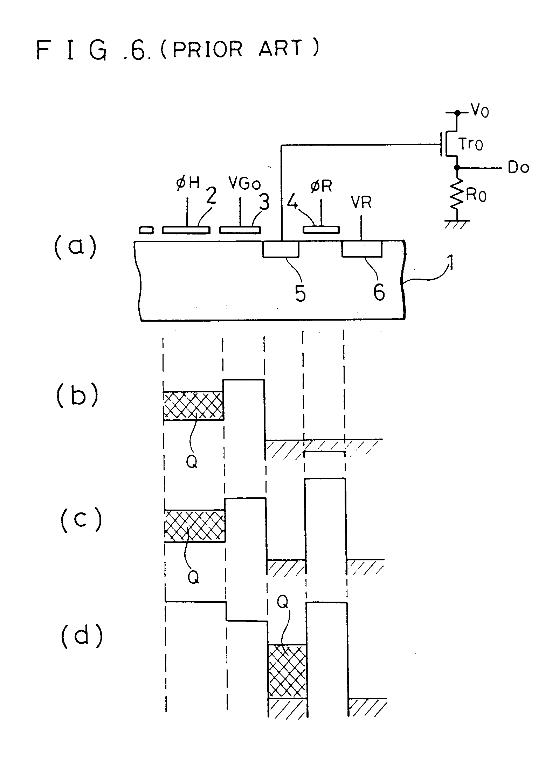

Figure 6(a) shows a cross-sectional structure of a case where such floating diffusion type amplifier is used as an output circuit of CCD. In figure 6(a), at a predetermined position on a first conductivity type semiconductor substrate 1, a CCD final gate electrode 2 and a voltage barrier production gate electrode 3 are arranged. One of the driving clocks for the charge transfer $\phi H$ is applied to the gate electrode 2 and a DC voltage $VG_0$ is applied to the gate electrode 3. At a region adjacent to the gate electrode 3, a MOS transistor comprising a gate electrode 4 and second conductivity type high concentration impurity regions 5 and 6 is produced. To the gate electrode 4 of this MOS transistor, a reset clock $\phi R$ is applied, and by making this reset clock $\phi R$ at high level, the MOS transistor is turned on. Further, a reset power supply VR is connected to the impurity region 6.

The impurity region 5 is called as a floating diffusion, and it is connected to a gate of a source follower transistor $Tr_0$ for outputting which is produced on the same semiconductor substrate 1. A source follower power supply $V_0$ is applied to the drain of the transistor $Tr_0$. Further, the source of the transistor $Tr_0$ is grounded by a load resistance $R_0$ and an output $D_0$ is output from the connection node of the source and the load resistance $R_0$.

The device will operate as follows.

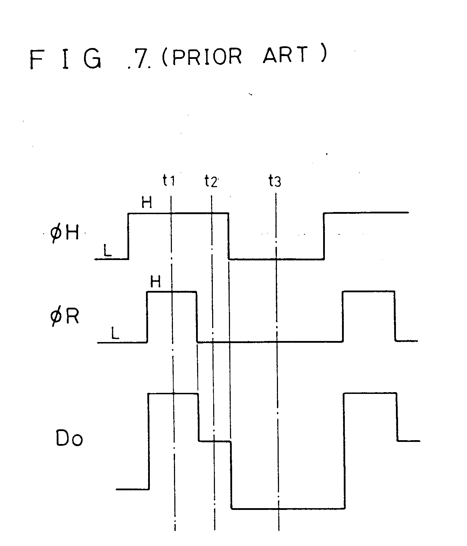

Figure 6(b) to (d) show potentials of the respective portions of figure 6(a) at timings corresponding to $t_1$ to $t_3$, respectively, of the clock timing chart of figure 7.

First of all, at time $t_1$ of figure 7, the driving clock $\phi H$ is at high level, and a potential well is produced at below the gate electrode 2 as shown in figure 6(b), thereby to store signal charges Q. At the same time, the clock reset $\phi R$ is at high level, and the MOS transistor constituted by the gate electrode 4 and the impurity regions 5 and 6 is turned on, and the voltages of the impurity region 5 and the gate of the transistor $Tr_0$ which is connected thereto are reset to the reset power supply voltage VR.

Next, at time $T_2$ of figure 7, the reset clock $\phi R$ becomes low level, and the MOS transistor constituted by the gate electrode 4 and the impurity region 5 is turned off (refer to figure 6(c)). When the reset clock $\phi R$ changes to low level from high level, the voltage of the impurity region 5 is lowered due to the capacitance coupling between the gate electrode 4 and the impurity region 5 during the period of the reset clock $\phi R$ being low level, and the node connected to the impurity region 5 becomes floating.

Next, at time $T_3$ of figure 7, when the driving clock $\phi H$ becomes low level, the signal charges Q stored at the potential well below the gate electrode 2 is read out to the impurity region 5 (refer to figure 6(d)), and the voltage of the node of the impurity region 5 is changed, and this voltage change is output through the source follower circuit. The amplitude of the output $\Delta V$ is represented by the following formula when the capacitance of the floating diffusion node is made $C_{FD}$ and the gain of the source follower is made G,

$$\Delta V = \frac{G \cdot Q}{C_{FD}} \quad (1)$$

The gain of the source follower is usually about 0.7 to 0.9 without variations, and in order to increase $\Delta V$ against the same charge quantity Q, it is necessary to lower the capacitance $C_{FD}$. As $\Delta V$ is larger against the same charge quantity Q, the charge-voltage conversion gain is larger, and this is advantageous in view of S/N.

On the other hand, the charge maximum quantity which can be detected by the charge detection circuit is up to the charge quantity which gives a voltage change which would not exceed the channel potential below the gate electrode 3 even when the signal charges are stored at the impurity region 5, and thus the capacitance $C_{FD}$ determines the maximum quantity of charges which can be detected. When the $C_{FD}$ is tried to be reduced thereby to increase the charge-voltage conversion gain, the voltage change of the floating diffusion portion is increased but the maximum charge quantity capable of being detected is reduced.

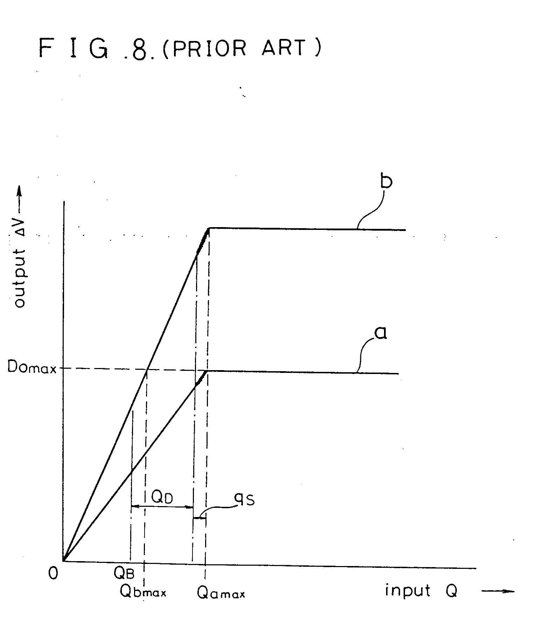

Figure 8 shows the relation between the quantity Q of signal charges which are electrically and optically generated by the CCD and the amplitude of the output of the source follower transistor $\Delta V$. As shown in the figure, the relation between the Q and $\Delta V$ is linear up to the saturation level $D_{0max}$ of the output which is determined by the design of CCD and the circuit system of the source follower transistor. When it exceeds the level, the output $\Delta V$ is saturated against the input Q, or shifted from linear characteristics. When the capacitance $C_{FD}$ is decreased and the amplitude $\Delta V$ of the output against the charge quantity Q of the input is increased from a to b as shown in the figure, thereby to increase the charge-voltage conversion gain, the maximum charge quantity is reduced from $Qa_{max}$ to $Qb_{max}$, and a small signal charge $q_s$ which is superimposed on the background cannot be detected.

Charge detection circuits are described in IBM Technical Disclosure Bulletin, vol. 22, no. 7, Dec. 1979 at pages 2978 and 2979 and also in US Patent No. 3,969,634. However these prior documents do not provide an adequate solution to the above mentioned problems.

Thus the present invention is concerned with providing a method of driving a charge detection circuit in which the detectable maximum charge quantity would not be reduced even when the charge-voltage conversion gain is increased.

According to the present invention, there is provided a method of driving a charge detection circuit of floating diffusion amplifier type which circuit comprises:

a second conductivity type diffusion region produced on a first conductivity type semiconductor substrate or layer;

a voltage barrier production gate electrode provided adjacent to said diffusion region;

a second gate electrode provided adjacent to said voltage barrier production gate electrode and providing a potential well for receiving signal charges;

a MOS transistor for resetting said diffusion region and in which said diffusion region acts as a source electrode; and

a source follower circuit for receiving the voltage of said diffusion region as an input and outputting a signal corresponding to said input signal, said method being characterised by:

transferring to the voltage well below said second gate electrode signal charges which are greater than the capacity of said well, and transferring part of the charges from the well to said diffusion region portion by exceeding a voltage barrier generated by said voltage barrier production gate electrode so as to maintain the depth of said well substantially constant.

In order that the present invention may be more readily understood, embodiments thereof will now be described by way of example and with reference to the accompanying drawings, in which:

Figure 1 is a diagram showing a cross-sectional structure of a charge detection circuit according to a method of driving a charge detection circuit as a first embodiment of the present invention and the potentials at the respective portions of the circuit;

Figure 2 is a diagram showing clock timings of the driving method of the above-described first embodiment;

Figure 3 is a diagram showing a cross-sectional structure according to a second embodiment of the present invention and the potentials at the respective portions of the circuit;

Figure 4 is a diagram showing the clock timings of the driving method of the second embodiment;

Figure 5 is a diagram showing the waveform of the voltage applied to the gate electrode according to a third embodiment of the present invention;

Figure 6 is a diagram showing a cross-sectional structure of a charge detection circuit according to the prior art and the potentials at the respective portions of the circuit;

Figure 7 is a diagram showing clock timings for explaining the operation of the prior art device; and

Figure 8 is a diagram showing the relation between the signal charge quantity Q and the output $\Delta V$ of the charge detection circuit.

## DETAILED DESCRIPTION OF THE PREFERRED EMBODIMENTS

An embodiment of the present invention will be described in detail with reference to the drawings.

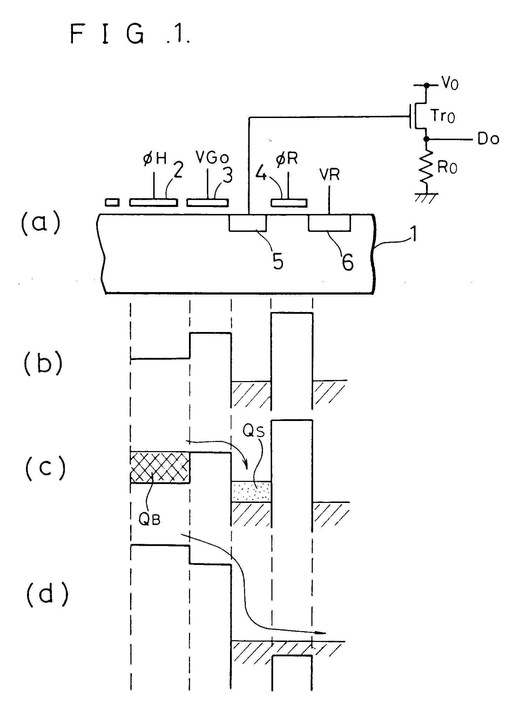

Figure 1(a) is a diagram showing a cross-sectional structure of a charge detection circuit which is employed in a method of driving a charge detection circuit according to a first embodiment of the present invention. This charge detection circuit has the same structure as that shown in figure 6(a).

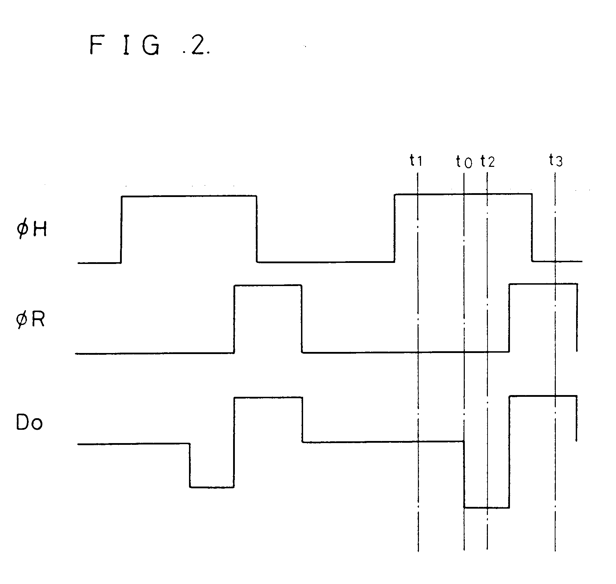

The driving method of the charge detection circuit according to the first embodiment of the present invention will be described. Figures 1(b) to (d) show potentials of respective portions of figure 1(a) at times corresponding to $t_1$ to $t_3$ of the clock timing charts of figure 2. In figure 2, $t_0$ designates a timing when signal charges are transferred to the voltage well below the CCD final gate electrode 2.

First of all, at time $t_1$ of figure 2, the driving clock $\phi H$ is at high level, and a voltage well is produced at below the gate electrode 2 as shown in figure 1(b). The floating diffusion is in a reset state.

Next, at time $t_2$ of figure 2, signal charges are transferred to the voltage well below the gate electrode 2 at time $t_0$. Then, the signal charges $Q_S$ (= $Q_D$ + $q_s$) which have overflown with remaining signal charges $Q_B$ which are stored at the capacitance of the voltage well below the gate electrode 2, will exceed the potential barrier below the voltage barrier production gate electrode 3 and are transferred to the impurity region 5 of floating diffusion, and the voltage change of the floating diffusion portion due thereto are read out through the source follower circuit (refer to figure 1(c)).

Next, at time $t_3$ of figure 2, the reset clock $\phi R$ is made high level, and the MOS transistor comprising the gate electrode 4 and the impurity regions 5 and 6 is turned on, and the $\phi H$ is made low level, and the signal charges $Q_B$ stored at below the gate electrode 2 flow into the reset power supply VR through the channel below the gate electrode 2 and the MOS transistor, and the floating diffusion is reset (refer to figure 1(d)). Accordingly, in this embodiment, the component $Q_S$ except for the background component $Q_B$ among the entirety of charge quantity Q (= $Q_B$ + $Q_s$) is detected.

In this embodiment, the signal charge quantity $Q_S$ (= $Q_D$ + $q_s$) which is obtained by subtracting the background component $Q_B$ of a predetermined quantity from the signal charge quantity Q (= $Q_B$ + $Q_D$ + $q_s$) which has been conventionally detected is detected as discussed above. Therefore, the small signal charge quantity $q_s$ which is superimposed on the background can be surely detected even when the charge-voltage conversion gain is increased. Further, the saturation level $D_{0max}$ of the output may be determined by circuit design to such a value that the maximum quantity of signal charge quantity $Q_s$ can be detected, thereby enabling to increase the detectable maximum charge quantity.

In the present invention, in order to detect the small signal charges superimposed on the background, the background component $Q_B$ of signal charge quantity Q is subtracted at the final stage for obtaining the output by the charge detection circuit. However, it is also conceived to subtract the background of the signal charges for respective picture elements. In this case, however, there are generated fixed pattern noises for respective picture elements, thereby arising variations of output. To the contrary, in the present invention, the quantity of background to be subtracted can be made always constant, thereby arising no such problems.

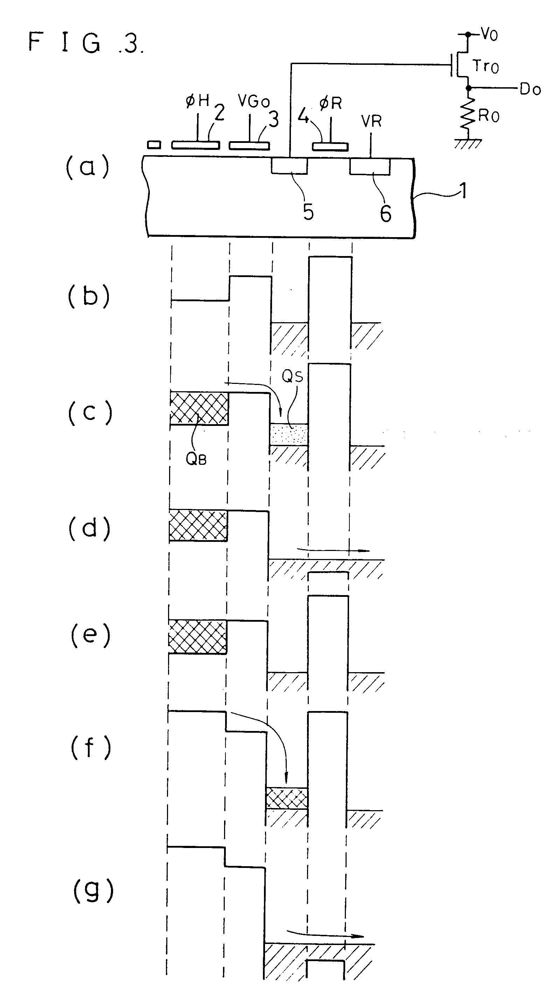

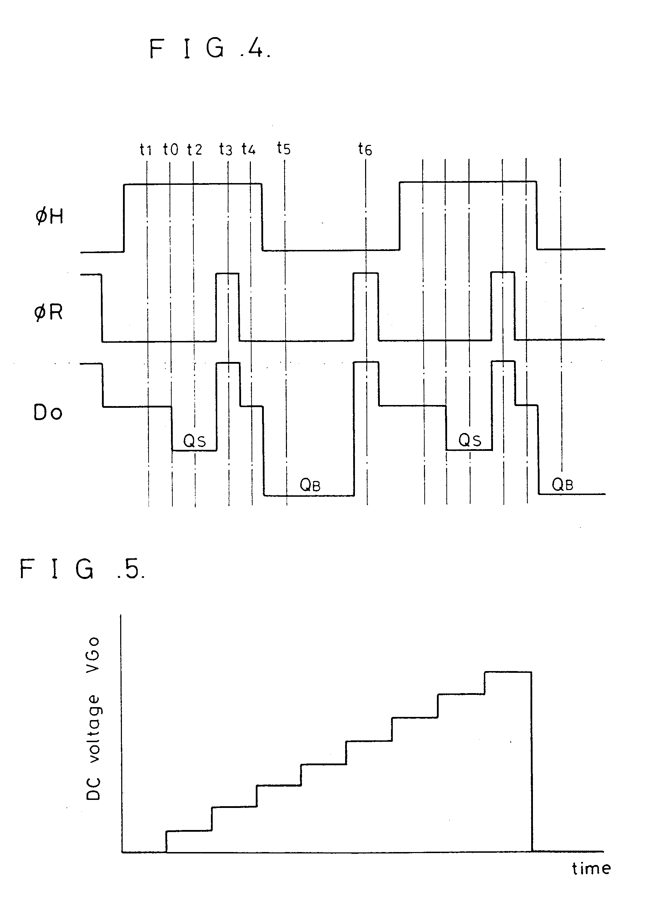

Figures 3 and 4 show a method of driving a charge detection circuit according to a second embodiment of the present invention. Figure 3 corresponds to figure 1 of the first embodiment and figure 4 corresponds to figure 2 thereof. In figure 4, the operations at timings corresponding to $t_1$ to $t_2$ are the same as those in the above-described first embodiment, and operations at the timings of $t_3$ to $t_6$ will be described.

First of all, at time $t_3$ of figure 4, $\phi R$ is made at a high level thereby to extract the signal charges $Q_S$ (= $Q_D$ + $q_s$) at the floating diffusion to the reset power supply VR as well as to reset the voltage of the floating diffusion portion (figure 3(d)).

Next, the $\phi R$ becomes low level at time $t_4$ of figure 4, and the floating diffusion portion comes into a floating state (refer to figure 3(e)).

Next, at time $t_5$ of figure 4, the $\phi H$ becomes low level, and signal charges $Q_B$ stored at below the gate electrode 2 are transferred to the floating diffusion portion exceeding over the potential barrier produced at below the gate electrode 3, and the voltage change of the floating diffusion portion due thereto is read out through the source follower (refer to figure 3(f)).

Next, at time $t_6$ of figure 4, the $\phi R$ is again made at high level, and the signal charges $Q_B$ which have been stored at the floating diffusion are extracted to the reset power supply VR and the voltage of the floating diffusion portion is reset (refer to figure 3(g)).

This second embodiment has a characteristics that the background component $Q_B$ which is included in the signal component can be also detected as compared with the first embodiment. Accordingly, when such a delay circuit is provided at outside the circuit to measure the sum of the signal component $Q_S$ and the background component $Q_B$, it is enabled to detect the entirety of charge quantity, as is quite effective in a case where the absolute quantity of signal is required, as a case where the temperature measurement is conducted with utilizing infrared rays.

Furthermore, the quantity of background component $Q_B$ can be controlled by the DC voltage $VG_0$ which is applied to the gate electrode 3 in the above described first and second embodiments. However, as shown in the third embodiment of the present invention shown in figure 5, it may be operated such that the voltage $VG_0$ is varied in a step configuration during the signal reading out periods, thereby to extract signal charges which are stored at the floating diffusion to the reset power supply at each step as well as to reset the voltage of the floating diffusion portion. In such embodiment, the output which is determined by the level $VG_0$ may be successively obtained, and when the capacitance below the CCD final gate electrode is sufficiently large, the maximum charge quantity can be determined in accordance with the cycle time of reading out steps, and the detectable maximum charge quantity can be further increased, when the cycle time of reading out steps are numerous. This is effective in a variety of digital processings.

While in the above-illustrated embodiment an output circuit of CCD is described, the present invention may be applied to any type of integrated circuits such as MOS type image sensors which require conversion of charges to a voltage.

While in the above-illustrated embodiment a source follower circuit one stage is provided and a resistor is employed for the load thereof, there may be provided a plurality of stages of source follower circuits and the load may comprise a transistor with the same effects as described above.

While in the above-illustrated embodiment a charge detection circuit having a MOS type transistor constituted by producing second conductivity type impurity regions on a first conductivity type semiconductor substrate is described, the present invention may not be restricted to this structure, and it may be replaced by a first conductivity type semiconductor layer such as well which is produced on a second conductivity type semiconductor substrate.

Furthermore, since the present invention can be accomplished by a similar structure as that of the prior art device, an alternative usage of the prior art method and the present invention method can be simply conducted by an alteration of driving at the outside, thereby enabling operations at a plurality of modes.

Furthermore, the present invention may not be restricted to those having the above-described timing relations, and timing relations which enable the above-described operation may be employed.

As is evident from the foregoing description, according to the present invention, the charge quantity which can be stored at below the gate electrode direct before the charge detection circuit is made a charge quantity which is to be extracted as unrequired charge, and the extra signal charges which cannot be stored at below the gate electrode when signal charges are transferred to below the gate electrode are detected by a charge detection circuit, and a signal which is obtained by extracting the background component of a predetermined quantity from the signal charges are output to be detected. Therefore, the carrier-voltage conversion gain of the charge detection circuit can be increased and the detectable maximum charge quantity can be also increased.

## Claims

1. A method of driving a charge detection circuit of floating diffusion amplifier type, which circuit comprises:

a second conductivity type diffusion region (5) produced on a first conductivity type semiconductor substrate or layer (1);

a voltage barrier production gate electrode (3) provided adjacent to said diffusion region (5);

a second gate electrode (2) provided adjacent to said voltage barrier production gate electrode (3) and providing a potential well for receiving signal charges;

a MOS transistor for resetting said diffusion region (5) and in which said diffusion region (5) acts as a source electrode; and

a source follower circuit for receiving the voltage of said diffusion region (5) as an input and outputting a signal corresponding to said input signal, said method being characterised by:

transferring to the voltage well below said second gate electrode (2) signal charges which are greater than the capacity of said well, and transferring part of the charges from the well to said diffusion region portion by exceeding a voltage barrier generated by said voltage barrier production gate electrode (3) so as to maintain the depth of said well substantially constant.

2. A method as claimed in claim 1, wherein when the signal charges are transferred to the voltage well below the said second gate electrode (2), the charges output to the diffusion region portion over said voltage barrier generate a first output signal, and after said first output signal is reset, the charges remaining below the second gate electrode (2) are output to the diffusion region portion as a second output signal.

3. A method as claimed in either claim 1 or claim 2, wherein the voltage applied to said voltage barrier production gate electrode (3) during said signal outputting period is varied in a step configuration.

4. A method as claimed in claim 3, wherein a voltage corresponding to charges output to said diffusion region portion at every step is output through said source follower circuit.

5. A method of driving a charge detection circuit as defined in claim 5, wherein said source follower circuit is constituted as a multi-stage.

## Patentansprüche

1. Verfahren zum Ansteuern einer Ladungserfassungsschaltung des schwebenden Diffusionsverstärkertyps, wobei die Schaltung aufweist:

einen Diffusionsbereich (5) des zweiten Leitfähigkeitstyps, der auf einem Halbleitersubstrat oder einer - schicht (1) des ersten Leitfähigkeitstyps hergestellt ist;

eine angrenzend an den Diffusionsbereich (5) vorgesehene Gateelektrode (3) zur Erzeugung einer Spannungsbarriere;

eine zweite Gateelektrode (2), die angrenzend an die zur Erzeugung der Spannungsbarriere vorgesehene Gateelektrode (3) vorgesehen ist und eine Potentialsenke zum Empfang von Signalladungen liefert;

einen MOS-Transistor, der zum Zurücksetzen des Diffusionsbereichs (5) dient und in dem der Diffusionsbereich (5) als Sourceelektrode wirkt; und

eine Sourcefolgerschaltung, die die Spannung des Diffusionsbereichs (5) als ein Eingangssignal empfängt und ein diesem Eingangssignal entsprechendes Signal ausgibt, wobei das Verfahren gekennzeichnet ist durch:

Übertragen der Spannungssenke unter die Signalladungen der zweiten Gateelektrode (2), die größer als die Kapazität der Senke sind, und Übertragen eines Teils der Ladungen aus der Senke zu dem Diffusionsbereichabschnitt durch Übersteigen einer Spannungsbarriere, die von der zur Erzeugung einer Spannungsbarriere vorgesehenen Gateelektrode (3) erzeugt wird, um die Tiefe der Senke im wesentlichen konstant zu halten.

2. Verfahren nach Anspruch 1, bei dem dann, wenn die Signalladungen zur Spannungssenke unter der zweiten Gateelektrode (2) übertragen werden, die zum Diffusionsbereichabschnitt über die zweite Spannungsbarriere ausgegebenen Ladungen ein erstes Ausgangssignal erzeugen, und nachdem das erste Ausgangssignal zurückgesetzt ist, die unterhalb der zweiten Gateelektrode (2) verbleibenden Ladungen zum Diffusionsbereichabschnitt als ein zweites Ausgangssignal ausgegeben werden.

3. Verfahren nach Anspruch 1 oder 2, bei dem die während des Signalausgabezeitraums an die zur Erzeugung einer Spannungsbarriere vorgesehene Gateelektrode (3) angelegte Spannung stufenartig geändert wird.

4. Verfahren nach Anspruch 3, bei dem über die Sourcefolgerschaltung eine Spannung ausgegeben wird, die Ladungen entspricht, die bei jedem Schritt an den Diffusionsbereichabschnitt ausgegeben werden.

5. Verfahren zum Ansteuern einer Ladungserfassungsschaltung nach Anspruch 5, bei dem die Sourcefolgerschaltung als Mehrfachstufe ausgebildet ist.

**Revendications**

1. Procédé pour commander un circuit de détection de charge du type amplificateur de diffusion flottant, lequel circuit comprend :

un région de diffusion d'un second type de conductivité (5) produite sur un premier substrat ou couche (1) semiconductrice d'un premier type de conductivité ;

une électrode de porte de production de barrière de tension (3) prévue adjacente à ladite région de diffusion (5) ;

une seconde électrode de porte (2) prévue adjacente à ladite électrode de porte de production de barrière de tension (3) et produisant un puits de potentiel pour recevoir des charges de signaux ;

un transistor MOS pour réajuster ladite région de diffusion (5) et dans lequel ladite région de diffusion (5) agit comme une électrode de source ; et

un circuit suiveur de source pour recevoir la tension de ladite région de diffusion (5) comme entrée et produire un signal correspondant audit signal d'entrée, ledit procédé étant caractérisé par :

transférer le puits de tension au-dessous de ladite seconde électrode de porte (2) des charges de signaux qui sont supérieures à la capacité dudit puits, et transférer une partie des charges du puits à ladite portion de région de diffusion en excédant une barrière de tension produite par l'électrode de porte de production de barrière de tension (3) afin de maintenir la profondeur dudit puits sensiblement constante.

2. Procédé comme revendiqué en revendication 1, dans lequel lorsque les charges de signaux sont transférées au puits de tension en dessous de la seconde électrode de porte précitée (2), les charges produites à la portion de région de diffusion au-dessus de la barrière de tension précitée produisent un premier signal de sortie, et après que ledit premier signal de sortie soit réinitialisé, les charges restant en dessous de la seconde électrode de porte (2) sont produites à la portion de région de diffusion comme second signal de sortie.

3. Procédé comme revendiqué en revendication 1 ou en revendication 2, dans lequel la tension appliquée à l'électrode de porte de production de barrière de tension précitée (3) pendant la période production du signal précité est variée dans une configuration en échelon.

4. Procédé comme revendiqué en revendication 3, dans lequel une tension correspondant à des charges produites à la portion de région de diffusion précitée à chaque échelon est produite par le circuit suiveur de source précité.

5. Procédé de commande d'un circuit de détection de charges comme défini en revendication 5 dans lequel un circuit suiveur de source est constitué en un étage multiple.

F I G .1.

(a)

(b)

(c)

(d)

F I G .2.

F I G .3.

F I G .4.

$\phi H$

$\phi R$

Do

Qs

QB

Qs

QB

t1 t0 t2 t3 t4 t5 t6

F I G .5.

DC voltage VGo

time

F I G .6. (PRIOR ART)

(a)

(b)

(c)

(d)

# F I G .7. (PRIOR ART )

# F I G .8. (PRIOR ART )